(19)

Europäisches Patentamt
European Patent Office
Office européen des brevets

(11) **EP 4 481 963 A1**

(12) **EUROPEAN PATENT APPLICATION**
published in accordance with Art. 153(4) EPC

(43) Date of publication:
**25.12.2024  Bulletin 2024/52**

(21) Application number: **23779543.0**

(22) Date of filing: **14.03.2023**

(51) International Patent Classification (IPC):
**H01S 5/11** *(2021.01)*        **H01S 5/185** *(2021.01)*

(52) Cooperative Patent Classification (CPC):
**H01S 5/11; H01S 5/185**

(86) International application number:
**PCT/JP2023/009788**

(87) International publication number:
**WO 2023/189523 (05.10.2023 Gazette 2023/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority:  **28.03.2022   JP 2022051401**

(71) Applicants:
• **Kyoto University
  Kyoto-shi, Kyoto 606-8501 (JP)**
• **Stanley Electric Co. Ltd.
  Tokyo 153-8636 (JP)**

(72) Inventors:
• **NODA, Susumu
  Kyoto-shi, Kyoto 606-8501 (JP)**
• **INOUE, Takuya
  Kyoto-shi, Kyoto 606-8501 (JP)**
• **SATO, Kazuki
  Tokyo 153-8636 (JP)**
• **FUJIWARA, Takako
  Tokyo 153-8636 (JP)**
• **EMOTO, Kei
  Tokyo 153-8636 (JP)**
• **KOIZUMI, Tomoaki
  Tokyo 153-8636 (JP)**

(74) Representative: **Wimmer, Hubert
  Wagner & Geyer Partnerschaft mbB
  Patent- und Rechtsanwälte
  Gewürzmühlstrasse 5
  80538 München (DE)**

(54) **SURFACE-EMITTING LASER ELEMENT**

(57)     A surface-emitting laser element includes a translucent substrate, an n-type semiconductor layer, an active layer, a p-type semiconductor layer, an air-hole layer that is a photonic crystal layer included in the n-type semiconductor layer, a light reflection layer provided on the p-type semiconductor layer and including a reflection surface; and a translucent conductor layer provided between the reflection surface and the p-type semiconductor layer. A light emission surface is provided on a back surface of the substrate, the air-hole layer has a diffraction surface that is a wave source when light standing in the air-hole layer is diffracted in a direction orthogonal to the air-hole layer, a weakening region where a separation distance between the diffraction surface and the reflection surface is provided such that a light intensity of interference light generated by interference of first diffracted light diffracted from the diffraction surface to the light emission surface side and second diffracted light diffracted from the diffraction surface to the light reflection layer side and reflected by the reflection surface is lower than a light intensity of the first diffracted light is provided, and a strengthening region where a separation distance between the diffraction surface and the reflection surface is provided such that the light intensity of the interference light is higher than the light intensity of the first diffracted light is provided.

EP 4 481 963 A1

**(Cont. next page)**

# FIG.3

CROSS
SECTION

RA

R2    R1    R2

10

31(2)    31(1)    32

SR1

SR2    d2    31    d1

d

15

WS    14P

14K    11

Ld    Lr

Ld    Lr    LS1

LS2

z

y    x

INTENSITY: LS

POSITION

BEAM

LS2>LS1    LS2    LS1

## Description

Technical Field

The present invention relates to a surface-emitting laser element, and particularly to a surface-emitting laser element including a photonic crystal.

Background Art

In recent years, the development of a photonic-crystal surface-emitting laser using a photonic crystal (PC) has progressed.

For example, Patent Literature 1 discloses a photonic-crystal surface-emitting laser including a single-lattice photonic crystal and having a high diffraction effect.

In addition, Patent Literature 2 discloses a photonic-crystal surface-emitting laser that includes a multi-lattice photonic crystal layer, has high flatness and crystallinity of an active layer, has a high light extraction efficiency, and can oscillate and operate with a low threshold value current density and a high quantum efficiency.

In addition, Patent Literature 3 discloses a vertical cavity light-emitting element having a light guide structure, the light-emitting element including: a central region; and a peripheral region that is provided around the central region and has a smaller optical path length between first and second multilayer film reflecting mirrors than the central region.

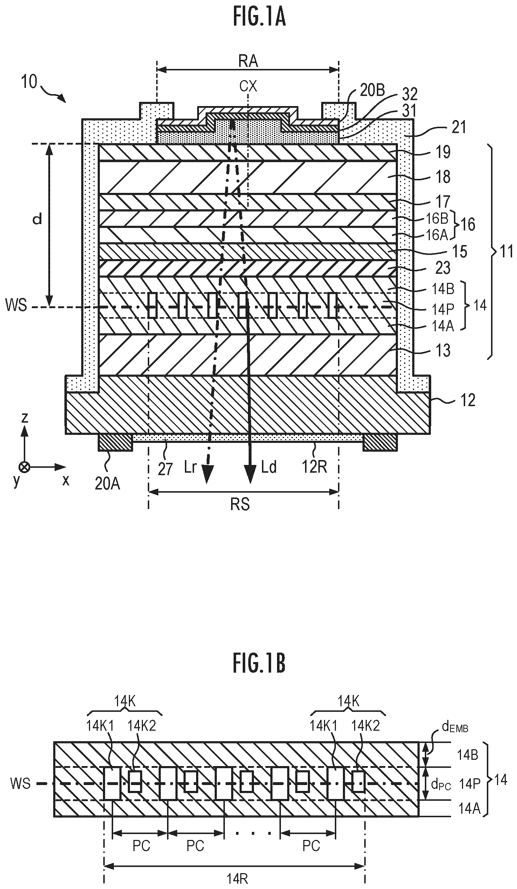

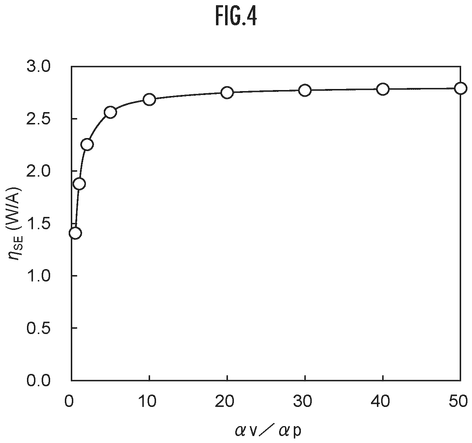

Non-Patent Literature 1 discloses formulation of diffracted light of a photonic-crystal surface-emitting laser, a diffracted radiated wave profile that is diffracted in a photonic crystal layer and emitted in a direction perpendicular to the photonic crystal layer, and the like (FIG. 1 and FIG. 4B).

Citation List

Patent Literatures

Patent Literature 1: Republished Patent WO2018-155710
Patent Literature 2: Japanese Patent Application Laid-Open No. 2020-045573
Patent Literature 3: Japanese Patent Application Laid-Open No. 2019-208004

Non-Patent Literature

Non-Patent Literature 1: Y. Liang et al.: Phys. Rev. B vol. 84, 195119 (2011)

Summary of Invention

Technical Problem

In the vertical cavity light-emitting element in the related art, a light guide layer that includes regions having different optical path lengths is provided in a resonator to control a beam. Therefore, to stably generate high-output monomodal laser light, the light guide layer needs to be formed in consideration of an oscillation mode. In addition, the same also applies to a case where laser light having a multimodal intensity distribution is generated and emitted (for example, Patent Literature 3).

The present invention has been made focusing on a point that a beam shape is controlled to a desired shape by controlling diffracted light that is diffracted and emitted from a photonic crystal (PC) layer, that is, light that is previously emitted instead of controlling an oscillation mode. As a result, a beam can be controlled irrespective of a laser oscillation mode. In other words, the beam shape can be easily and accurately controlled by using light not contributing to the oscillation.

The present invention has been made focusing on the above-described point, and an obj ect thereof is to provide a photonic-crystal surface-emitting laser where a beam shape can be easily and accurately controlled and beam (transverse mode) stability is excellent up to a high output.

Solution to Problem

A surface-emitting laser element according to a first aspect of the present invention includes:

a translucent substrate;

an n-type semiconductor layer provided on the substrate;

an active layer provided on the n-type semiconductor layer;

a p-type semiconductor layer provided on the active layer;

an air-hole layer that is a photonic crystal layer included in the n-type semiconductor layer and including air holes disposed with two-dimensional periodicity in a plane parallel to the active layer,

a light reflection layer provided on the p-type semiconductor layer and including a reflection surface; and

a translucent conductor layer provided between the reflection surface and the p-type semiconductor layer,

in which a light emission surface is provided on a back surface of the substrate,

the air-hole layer has a diffraction surface that is a wave source when light standing in the air-hole layer is diffracted in a direction orthogonal to the air-hole layer,

a weakening region where a separation distance between the diffraction surface and the reflection surface is provided such that a light intensity of interference light generated by interference of first diffracted light diffracted from the diffraction surface to the light emission surface side and second diffracted light diffracted from the diffraction surface to the light reflection layer side and reflected by the reflection surface is lower than a light intensity of the first diffracted light is provided, and

a strengthening region where a separation distance between the diffraction surface and the reflection surface is provided such that the light intensity of the interference light is higher than the light intensity of the first diffracted light is provided.

Brief Description of Drawings

FIG. 1A is a cross-sectional view schematically illustrating an example of a structure of a PCSEL element 10 according to a first embodiment of the present invention.

FIG. 1B is a partially enlarged cross-sectional view schematically illustrating an air-hole layer 14P (photonic crystal layer) of FIG. 1A and air holes 14K arranged in the air-hole layer 14P.

FIG. 2A is a plan view schematically illustrating an upper surface of the PCSEL element 10.

FIG. 2B is a cross-sectional view schematically illustrating a cross-section of the air-hole layer 14P in a plane parallel to an n-side guide layer 14.

FIG. 2C is a plan view schematically illustrating a lower surface of the PCSEL element 10.

FIG. 3 is a diagram illustrating a light interference layer 31 and a light reflection layer 32 of the PCSEL element 10 according to the first embodiment and interference of diffracted light.

FIG. 4 is a diagram illustrating a slope efficiency $\eta SE$ with respect to $\alpha v/\alpha p$.

FIG. 5 is a diagram illustrating dependence of the slope efficiency $\eta SE$ on a phase difference $\theta$ when Ag and Pd are used for a reflection metal layer.

FIG. 6 is a diagram illustrating a calculation result of an electric field amplitude of a radiated wave when light propagating in the air-hole layer 14P in an x-axis direction is diffracted by the air-hole layer and radiated in a perpendicular direction ($\pm z$ direction).

FIG. 7 is a diagram illustrating a relationship between the slope efficiency $\eta SE$ to the phase difference $\theta$ and an interference layer film thickness.

FIG. 8 is a schematic cross-sectional view illustrating a modification example of the first embodiment.

FIG. 9 is a diagram schematically illustrating a cross-section of a PCSEL element 50 according to a second embodiment, an interference light intensity, and a beam shape.

FIG. 10 is a diagram illustrating the phase difference ($\theta$) dependence of the interference layer thickness in a central region R1 where the light reflection layer 32(1) is Pd (R = 0.45).

FIG. 11 is a diagram schematically illustrating a cross-section of a PCSEL element 60 according to a third embodiment, an interference light intensity, and a beam shape.

Description of Embodiments

Hereinafter, preferred embodiments of the present invention will be described, but these embodiments may be appropriately modified and combined. In addition, in the following description and the accompanying drawings, substantially the same or equivalent parts will be described with the same reference numerals.

[First Embodiment]

1. Structure of Photonic-Crystal Surface-Emitting Laser

(a) Element Structure

A photonic-crystal surface-emitting laser (hereinafter, also referred to as a PCSEL) includes a resonator layer in a direction parallel to a semiconductor light-emitting structure layer (an n-side guide layer, a light-emitting layer, and a p-side guide layer) configuring a light-emitting element, and is an element that radiates coherent light in a direction orthogonal to the resonator layer.

On the other hand, a distributed Bragg reflector (DBR) laser is known, but a photonic-crystal surface-emitting laser (PCSEL) is different from the DBR laser in the following points. That is, in the photonic-crystal surface-emitting laser (PCSEL), a light wave propagating in a plane parallel to a photonic crystal layer is diffracted due to a diffraction effect of the photonic crystal to form a two-dimensional resonance mode and is also diffracted in a direction perpendicular to the parallel plane. That is, in the photonic-crystal surface-emitting laser, a light extraction direction is a direction perpendicular to the resonance direction (in-plane parallel to the photonic crystal layer).

FIG. 1A is a cross-sectional view schematically illustrating an example of a structure of a photonic-crystal surface-emitting laser element (hereinafter, also referred to as a PCSEL element) 10 according to a first embodiment of the present invention. As illustrated in FIG. 1A, a semiconductor structure layer 11 is formed on a translucent substrate 12. A semiconductor layer is laminated perpendicular to a central axis CX of the semiconductor structure layer 11.

In addition, the semiconductor structure layer 11 is made of a hexagonal nitride semiconductor. In the present embodiment, the semiconductor structure layer 11 is made of, for example, a GaN-based semiconductor.

More specifically, the semiconductor structure layer 11 including a plurality of semiconductor layers is formed on the substrate 12, that is, an n-cladding layer (first conductivity type first cladding layer) 13, an n-side guide layer (first guide layer) 14 that is a guide layer provided on the n side, a light distribution adjustment layer 23, an active layer (ACT) 15, a p-side guide layer (second guide layer) 16 that is a guide layer provided on the p side, an electron blocking layer (EBL) 17, a p-cladding layer (second conductivity type second cladding layer) 18, and a p-contact layer 19 are formed in this order. A case where the first conductivity type is an n-type and the second conductivity type that is a conductivity type opposite to the first conductivity type is a p-type will be described. However, the first conductivity type and the second conductivity type may be a p-type and an n-type, respectively.

The substrate 12 is a GaN single crystal substrate with a +c-plane in which a main surface is a {0001} plane on which Ga atoms are arranged on the outermost surface. The substrate 12 is not limited to this configuration, but a just substrate, or, for example, a substrate in which a main surface is offset to about 1° in an m-axis direction is preferable. For example, the substrate that is offset to about 1° in the m-axis direction can obtain mirror growth under a wide range of growth conditions.

A substrate surface (a back surface or a light emission surface) on which a light emission region 20L opposite to the main surface is the "-c" plane that is the (000-1) plane on which N atoms are arranged on the outermost surface. The -c-plane is resistant to oxidation or the like, and is thus suitable as a light extraction surface.

Hereinafter, configurations such as a composition and a layer thickness of each of the semiconductor layers will be described. However, these configurations are merely examples and can be appropriately modified and applied.

The n-cladding layer 13 is, for example, an n-type $Al_{0.04}Ga_{0.96}N$ layer (layer thickness: 2 $\mu$m) having an Al composition of 4%.

The n-side guide layer 14 includes a lower guide layer 14A, an air-hole layer 14P that is a photonic crystal layer (PC layer), and an embedded layer 14B.

The n-side guide layer 14 is, for example, an n-type GaN layer (layer thickness: 360 nm). The lower guide layer 14A of the n-side guide layer 14 is an n-type GaN layer (layer thickness: 200 nm). The air-hole layer 14P has a layer thickness (or a depth of the air holes 14K) of 90 nm. The embedded layer 14B is an n-type GaN layer (layer thickness: 90 nm).

The light distribution adjustment layer 23 is an undoped $In_{0.03}Ga_{0.97}N$ layer (layer thickness: 50 nm). The light distribution adjustment layer 23 also functions as an adjustment layer for adjusting the coupling efficiency (light field) between light and the air-hole layer 14P.

The active layer 15 that is a light-emitting layer is, for example, a multiple quantum well (MQW) layer including two quantum well layers. A barrier layer and the quantum well layer of the MQW are a GaN layer (layer thickness: 6.0 nm) and an InGaN layer (layer thickness: 3.0 nm), respectively. In addition, an emission wavelength of the active layer 15 is 435 nm.

The p-side guide layer 16 includes a p-side guide layer (1) 16A and a p-side guide layer (2) 16B. The p-side guide layer (1) 16A is an undoped $In_{0.02}Ga_{0.98}N$ layer (layer thickness: 70 nm), and the p-side guide layer (2) 16B is an undoped GaN layer (layer thickness: 180 nm).

The p-side guide layer 16 is set to be an undoped layer in consideration of light absorption by a dopant (Mg:

magnesium or the like), but may be doped to obtain excellent electrical conductivity. In addition, to adjust an electric field distribution in an oscillation operation mode, the In composition and the layer thickness of the p-side guide layer (1) 16A can be appropriately selected.

The electron blocking layer (EBL) 17 is an $Al_{0.2}Ga_{0.8}N$ layer (layer thickness: 15 nm), and the p-cladding layer 18 is an Mg-doped $p$-$Al_{0.06}Ga_{0.94}N$ layer (layer thickness: 290 nm). The p-contact layer 19 is an Mg-doped p-GaN layer (layer thickness: 25 nm).

In the present specification, an "n side" and a "p side" do not necessarily mean having an n-type and a p-type. For example, the n-side guide layer means a guide layer provided closer to the n side than the active layer, and may be an undoped layer (or an i layer).

In addition, the n-cladding layer 13 may include a plurality of layers instead of a single layer. In this case, all the layers do not need to be n layers (n-doped layers), and may include an undoped layer (i layer). The same also applies to the p-side guide layer 16 and the p-cladding layer 18. In addition, it is not necessary to provide all the above-described semiconductor layers, and any configuration may be adopted as long as the configuration includes an n-type semiconductor layer, a p-type semiconductor layer, and an active layer (light-emitting layer) interposed between these layers.

A light interference layer 31 is provided on the semiconductor structure layer 11, that is, the p-contact layer 19 (upper surface), and a light reflection layer 32 is provided on the light interference layer 31. In addition, a p-electrode (anode) 20B is provided on the light reflection layer 32. A forming region of the light interference layer 31 and the light reflection layer 32 will be referred to as an anode region RA.

Side surfaces and an edge portion of an upper surface in the semiconductor structure layer 11 are covered with an insulating film 21 such as $SiO_2$. In addition, the insulating film 21 is formed to cover side surfaces of the light interference layer 31, the light reflection layer 32, and the p-electrode 20B and an edge portion of an upper surface of the p-electrode 20B.

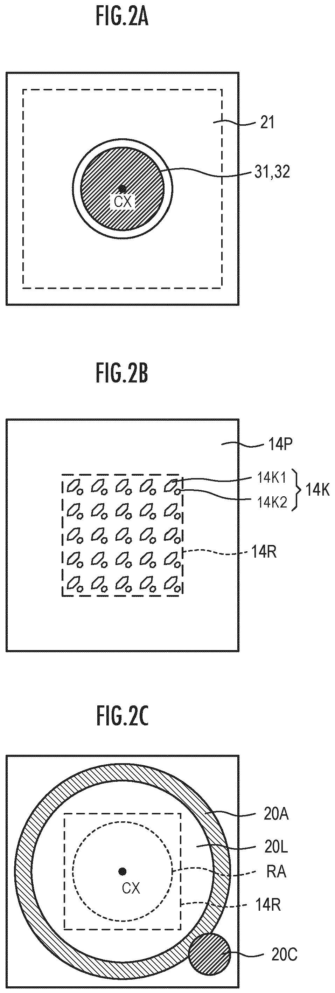

Radiated light from the active layer 15 is diffracted by the air-hole layer (PC layer) 14P. Light (direct diffracted light Ld: first diffracted light) diffracted by the air-hole layer 14P and directly emitted from the air-hole layer 14P, and light (reflected diffracted light Lr: second diffracted light) emitted due to diffraction of the air-hole layer 14P and reflected by the light reflection layer 32 are emitted to the outside from the light emission region 20L (FIG. 2C) of a back surface (emission surface) 12R of the substrate 12.

FIG. 1B is an enlarged cross-sectional view schematically illustrating the details of the air-hole layer 14P (photonic crystal layer) of FIG. 1A and air holes arranged in the air-hole layer 14P. In the present embodiment, in the air-hole layer 14P, air hole pairs 14K each of which consists of a main air hole 14K1 and a secondary air hole 14K2 are two-dimensionally arranged at square lattice point positions of lattice points. That is, the air-hole layer 14P is formed as an air-hole layer having a dual lattice structure.

The same is applicable to an air-hole layer having a single lattice structure (single hole) where one air hole is provided at a lattice point and a general air-hole layer having a multi-lattice structure. Accordingly, hereinafter, the air hole pairs 14K will be simply referred to as the air holes 14K.

More specifically, the air holes 14K have a period PC, for example, in a square lattice shape on a crystal growth plane (growth plane of the semiconductor layer), that is, a plane parallel to the n-side guide layer 14, and the air holes 14K are formed to be two-dimensionally arranged at square lattice point positions, respectively and embedded in the n-side guide layer 14.

FIG. 2A is a plan view schematically illustrating an upper surface of the PCSEL element 10, FIG. 2B is a cross-sectional view schematically illustrating a cross-section of the air-hole layer 14P in a plane parallel to the n-side guide layer 14, and FIG. 2C is a plan view schematically illustrating a lower surface of the PCSEL element 10.

As illustrated in FIG. 2B, in the air-hole layer 14P, the air holes 14K are periodically arranged and provided in, for example, a rectangular air hole forming region 14R. As illustrated in FIG. 2C, the anode region RA (the forming region of the light interference layer 31 and the light reflection layer 32) is formed to be in the air hole forming region 14R.

In addition, an inner diameter of an n-electrode 20A may be more than or equal to that of the anode region RA when seen from a direction perpendicular to the air-hole layer 14P.

A region inside the n-electrode 20A is the light emission region 20L. In addition, a bonding pad 20C that is electrically connected to the n-electrode 20 A and is connected to a wire for supplying power from the outside is provided.

(b) Light Interference Layer, Light Reflection Layer, and Interference of Diffracted Light

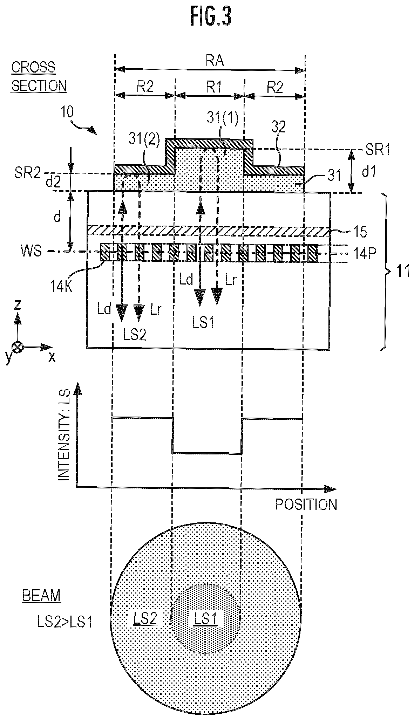

FIG. 3 is a diagram illustrating the light interference layer 31 and the light reflection layer 32 of the PCSEL element 10 according to the first embodiment and interference of diffracted light. More specifically, in FIG. 3, the upper section schematically illustrates a cross-section of the semiconductor structure layer 11, the light interference layer 31, and the light reflection layer 32, the middle section schematically illustrates an intensity of interference light LS generated by interference, and the lower section schematically illustrates a beam shape and an intensity of the interference light LS.

The light interference layer 31 is formed of a translucent conductor layer, for example, indium tin oxide (ITO). The light interference layer 31 is in ohmic contact with the p-contact layer 19. The light interference layer 31 is not limited to ITO and can be formed of a translucent conductor such as zinc tin oxide (ZTO).

The light interference layer 31 has a circular shape in a top view, that is, when seen from a direction (z direction) perpendicular to the semiconductor structure layer 11. Specifically, the light interference layer 31 consists of a light interference layer 31(1) in a central region R1 (hereinafter, also referred to as the first region) that has a circular shape and a layer thickness d1 and a light interference layer 31(2) in a peripheral region R2 (hereinafter, also referred to as the second region) that is a region outside the central region R1, has an annular shape concentric with the central region R1, and has a smaller layer thickness (layer thickness d2) than the central region R1 (d1 > d2). The light interference layer 31(1) and the light interference layer 31(2) will also be referred to as the first region layer and the second region layer, respectively.

In the present embodiment, a diameter of the central region R1 is 100 $\mu$m, and a diameter (outer diameter) of the peripheral region R2 is 300 $\mu$m (that is, an inner diameter is 100 $\mu$m). However, the diameters of the central region R1 and the peripheral region R2 can be appropriately set from the viewpoint of beam (transverse mode) control.

A metal layer is formed as the light reflection layer 32 on the light interference layer 31. In FIG. 3, the p-electrode 20B provided on the light reflection layer 32 is not illustrated.

The light reflection layer 32 reflects diffracted light from the air-hole layer 14P. The light reflection layer 32 is formed to cover the entire surface of the light interference layer 31.

As the light reflection layer 32, for example, silver (Ag) having a high reflectivity of 85% or palladium (Pd) having a reflectivity of 45% can be used. In addition, the layer thickness of the light reflection layer 32 is, for example, 200 nm, but is not limited thereto.

The p-electrode 20B provided on the light reflection layer 32 (refer to FIG. 1A) consists of, for example, Ti/Pt/Au, but is not limited thereto. As the p-electrode 20B, for example, Ti/Au, Ti/Al/Ti/Pt/Au, or Ni/Pt/Au can be used. In addition, the layer thickness of the p-electrode 20B may be increased to function as a pad electrode.

Regarding the semiconductor structure layer 11, each of the semiconductor layers other than the air-hole layer 14P and the active layer 15 is not illustrated to clarify the drawing. In addition, a distance between a diffraction surface WS of the air-hole layer 14P and an interface of the semiconductor structure layer 11 and the light interference layer 31 is represented by d.

The interference of the diffracted light in the PCSEL element 10 according to the present embodiment will be described below. The radiated light of the active layer 15 is diffracted by the air-hole layer 14P. In the diffracted light, the light (reflected diffracted light Lr) that is reflected by the light reflection layer 32 through the light interference layer 31(1) of the central region R1 interferes with the direct diffracted light Ld from the air-hole layer 14P such that interference light (combined light) LS1 is generated (interference light of the first region).

Likewise, in the peripheral region R2, the reflected diffracted light Lr transmitted through the light interference layer 31(2) of the peripheral region R2 interferes with the direct diffracted light Ld from the air-hole layer 14P such that interference light LS2 is generated (interference light of the second region).

A layer thickness d1 of the light interference layer 31(1) in the central region R1 is determined such that the direct diffracted light Ld and the reflected diffracted light Lr weaken each other. In addition, a layer thickness d2 of the light interference layer 31(2) in the peripheral region R2 is determined such that the direct diffracted light Ld and the reflected diffracted light Lr strengthen each other.

Accordingly, intensities of the interference light LS1 and the interference light LS2 that are generated in the central region (first region) R1 and the peripheral region (second region) R2 and emitted satisfy LS1 < LS2. That is, the peripheral region R2 is a region brighter than the central region R1.

For clear description and easy understanding, the intensities of the interference light LS1 and the interference light LS2 will be described as the interference light intensity LS1 and the interference light intensity LS2 using the same reference numerals, respectively. In addition, when the interference light LS1 and the interference light LS2 do not need to be distinguished from each other, the interference light LS1 and the interference light LS2 will be collectively referred to as the interference light LS.

2. Slope Efficiency of PCSEL Element

(a) Slope Efficiency of PCSEL Element in consideration of Reflection of Reflection Surface

As illustrated in FIG. 3, when the air-hole layer (photonic crystal layer) 14P is on an xy plane, light propagating in the air-hole layer 14P forms a standing wave in the xy plane, and a part of the light is diffracted by the photonic crystal in the z-axis direction orthogonal to the xy plane and emitted as laser light.

Reflection surfaces SR1 and SR2 (hereinafter, referred to as the reflection surface SR when they do not need to be distinguished from each other) of the light reflection layer 32 in the central region R1 and the peripheral region R2 are on a plane parallel to the air-hole layer 14P, and laser light diffracted by the air-hole layer 14P and the reflection surface SR are orthogonal to each other.

In the PCSEL element 10, it is necessary to consider absorption on the reflection surface SR and interference of incidence light and reflected light to consider the emission efficiency.

A resonator loss in the PCSEL element 10 is divided into a loss component $\alpha$p in a direction in the same plane (in the xy plane) as the air-hole layer 14P and a loss component $\alpha$v in a perpendicular direction (z direction) orthogonal to the air-hole layer 14P. Among these components, the component $\alpha$v in the perpendicular direction contributes to laser emission. However, when the reflection surface SR is present, it is necessary to consider absorption and reflection on the reflection surface SR to consider the emission efficiency.

In the present specification, the loss $\alpha$p in the in-plane direction, the loss $\alpha$v in the perpendicular direction, and the slope efficiency $\eta$SE are represented by as follows.

$\alpha_{//}, \alpha_v, \eta_{SE}$

The component radiated in the perpendicular direction by diffraction is $\alpha$v. Therefore, assuming that diffraction occurs uniformly in the vertical direction ($\pm$z direction) of the z-axis, the energy emitted in the $\pm$z direction is the same, and thus the laser light radiated in the $\pm$z direction is 0.5 $\alpha$v.

When the reflectivity of the reflection surface SR is represented by R, in the laser light radiated in the direction (+z direction) of the reflection surface SR, the component absorbed by SR is 0.5 $\alpha$v(1 - R), and the component reflected by SR is 0.5 $\alpha$vR. When a phase difference between light emitted in a direction from the air-hole layer 14P to the emission surface 12R and light reflected in a direction from the reflection surface SR to the emission surface 12R is represented by $\theta$, an effective radiation coefficient $\alpha$v1 at which the light is emitted from the emission surface is represented by Expression (1.1) below.

$$\alpha_{v1} = 0.5\alpha_v + 0.5\alpha_v R + 2(0.5\alpha_v)^{0.5} * (0.5\alpha_v R)^{0.5} \cos\theta$$
$$= 0.5(1 + 2R^{0.5}\cos\theta + R)\alpha_v \qquad (1.1)$$

In addition, the loss absorbed by the reflection surface SR is 0.5 $\alpha$v(1 - R). At this time, the radiation loss $\alpha$ is represented by Expression (1.2) below.

$$\alpha = 0.5(1 + 2R^{0.5}\cos\theta + R)\alpha_v + 0.5\alpha_v(1 - R)$$
$$= (1 + R^{0.5}\cos\theta)\alpha_v \qquad (1.2)$$

Accordingly, the slope efficiency $\eta$SE (emission efficiency) in consideration of the reflection surface SR in the PCSEL element 10 is represented by Expression (1.3) below.

$$\eta_{SE} = \frac{h\nu}{e}\eta_i \frac{\text{Component Contributing to Emission}}{\text{Sum of Total Loss}}$$
$$= \frac{h\nu}{e}\eta_i \frac{\alpha_{v1}}{\alpha + \alpha_{//} + \alpha_i} = \frac{h\nu}{e}\eta_i \frac{\frac{1}{2}(1 + 2\sqrt{R}\cos 0 + R)\alpha_v}{(1 + \sqrt{R}\cos\theta)\alpha_v + \alpha_{//} + \alpha_i} \qquad (1.3)$$

In the above expression, $\eta$i is an injection efficiency during a laser oscillation operation. In addition, in the above expression, in addition to the resonator loss, an internal loss $\alpha$i by material absorption is considered.

When the internal loss $\alpha$i = 0, Expression (1.3) is represented by Expression (1.4).

$$\eta_{SE} = \frac{h\nu}{e}\eta_i \frac{\frac{1}{2}(1 + 2\sqrt{R}\cos\theta + R)}{(1 + \sqrt{R}\cos\theta) + \alpha_{//}/\alpha_v} \qquad (1.4)$$

That is, as $\alpha$v/$\alpha$p increases, the higher the slope efficiency $\eta$SE can increase. Then, in the ideal case where $\eta$i = 1, R = 1, $\theta$ = 0, and $\alpha$i = 0, the slope efficiency $\eta$SE with respect to $\alpha$v/$\alpha$p is illustrated in FIG. 4.

As illustrated in FIG. 4, when $\alpha$v/$\alpha$p is about 20 or more, the slope efficiency $\eta$SE is saturated. Accordingly, from the viewpoint of increasing the slope efficiency $\eta$SE, $\alpha$v is preferably about 20 times $\alpha$p.

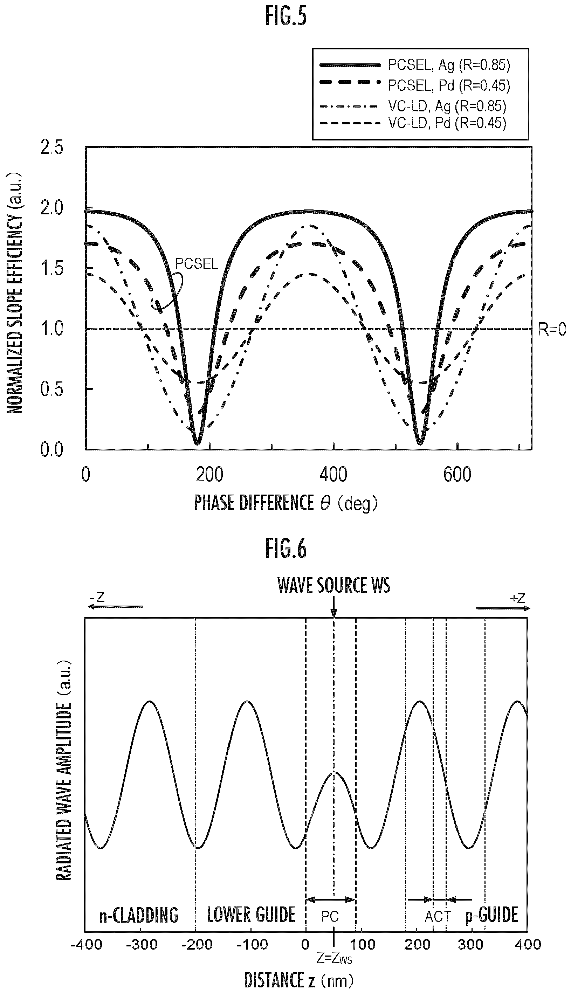

FIG. 5 illustrates dependence of the slope efficiency $\eta$SE on the phase difference $\theta$ when $\alpha$v/$\alpha$p = 20 and ITO/Ag (reflectivity R = 0.85) and ITO/Pd (reflectivity R = 0.45) are used as a reflection electrode. The slope efficiency $\eta$SE is normalized with the slope efficiency where there is no reflection.

In addition, the dependence of the slope efficiency on the phase difference θ in a vertical cavity laser (VC-LD) not including a photonic crystal layer is also illustrated.

In the vertical cavity laser (VC-LD), the slope efficiency changes in a cos-shaped curve depending on the phase difference θ. That is, a region (hereinafter, referred to as the strengthening region) where the radiation intensity is relatively strong and a region where the radiation intensity is relatively weak periodically appears at an interval of $2\pi$.

On the other hand, in the PCSEL element that resonates in the horizontal direction (the in-plane direction of the air-hole layer), an element region (hereinafter, referred to as the strengthening region) where the direct diffracted light Ld and the reflected diffracted light Lr strengthen each other in the perpendicular direction of the air-hole layer and an element region (hereinafter, referred to as the weakening region) where the direct diffracted light Ld and the reflected diffracted light Lr weaken each other are different from those of another light-emitting device such as a vertical cavity laser. The reason for this is that the total loss ($\alpha$total) contributing to oscillation is the sum ($\alpha$total = $\alpha$v + $\alpha$i + $\alpha$p) of $\alpha$v (loss by emission), $\alpha$i (loss by components), and $\alpha$p (loss relating to resonance) and the interference of the light emitted in the perpendicular direction relate to $\alpha$v and $\alpha$i.

As illustrated in FIG. 5, in the PCSEL element, the range of the phase difference θ in the strengthening region is wide, and the range of the phase difference θ in the weakening region is narrow.

That is, the layer thickness allowable range of the interference layer of the strengthening region is wide, the film thickness control is facilitated, and the emission intensity can be controlled. In addition, the ranges of the phase differences θ in the strengthening region and the weakening region of the PCSEL element vary depending on the reflectivity of the reflection layer.

Accordingly, in the PCSEL element, the allowable width of the layer thickness range of the interference layer of the weakening region is narrow. However, by decreasing the reflectivity of the reflection layer positioned in the weakening region, the allowable width of the layer thickness range of the weakening region is widened, and the control of the emission intensity is facilitated as in the strengthening region.

(b) Wave Source (Diffraction Surface) Position

A radiated wave profile radiated in a direction perpendicular to the air-hole layer 14P in the PCSEL element 10 according to the first embodiment is calculated.

More specifically, for example, based on Non-Patent Literature 1, light propagating in the xy direction (in-plane direction) of the air-hole layer 14P, the wave source (diffraction surface) of the diffracted wave by the air-hole layer 14P, and the radiated wave radiated in the perpendicular direction by diffraction can be calculated using a coupled wave theory.

FIG. 6 is a diagram illustrating a calculation result of an electric field amplitude of a radiated wave when light propagating in the air-hole layer 14P in the x-axis direction is diffracted by the air-hole layer 14P and radiated in a perpendicular direction ($\pm$z direction).

In the calculation, the air hole filling factor FF is 10%. In addition, in a nitride material system, when the air holes are embedded in the layer grown on the +C-plane substrate, it is known that the air hole has a hexagonal columnar structure whose side surfaces have the m-plane due to mass transport generated during the embedment growth (for example, Patent Literature 1). Therefore, here, the air holes 14K of the air-hole layer 14P are assumed to have a hexagonal columnar structure having a central axis extending in the z-axis direction, and the calculation is performed. In addition, the air hole period PC is 176 nm.

As illustrated in FIG. 6, an aspect can be seen that the light diffracted by the air-hole layer 14P is radiated, as radiated light, symmetrically in the +z-axis direction and the -z-axis direction at a certain point (a point on the z-axis) as a starting point in the air-hole layer 14P.

Since it can be assumed that the radiated wave is radiated from the starting point ($z = z_{ws}$) in the air-hole layer 14P, the point is the diffraction surface (wave source) WS in the device. Then, a surface that satisfies $z = z_{ws}$ and is parallel to the air-hole layer 14P is a diffraction surface and functions as a wave source. Hereinafter, for ease of understanding and simplicity of description, the same reference numerals are used and the surface is described as the diffraction surface WS. In other words, a symmetrical center surface of an electric field amplitude when the light standing in the air-hole layer 14P is diffracted symmetrically in a direction orthogonal to the air-hole layer 14P, is the diffraction surface WS.

An electric field profile in a fundamental mode changes depending on the lattice structure (a single lattice structure or a multi-lattice structure) of the air-hole layer. Therefore, the position of the diffraction surface WS changes depending on the lattice structure of the air-hole layer.

(c) Derivation of Layer Thickness of Light Interference Layer 31

First, when an average refractive index of a material configuring a range from the diffraction surface (wave source) WS to the reflection surface SR at a wavelength $\lambda$ of emitted light is represented by nave, a separation distance dr between the diffraction surface WS and the reflection surface SR can be represented by Expression (2.1) below.

$$dr = \left(\frac{\theta}{360°} + 0.5 + m\right)\frac{\lambda}{2n_{ave}} \qquad (2.1)$$

Expression (2.1) can be derived from Expression (2.2) below.

$$kx = \left(\frac{\theta}{360}2\pi + \pi + 2m\pi\right),\ k = \frac{2\pi}{\lambda},\ x = 2n_{ave}dr \qquad (2.2)$$

When a distance d between the diffraction surface WS and the light interference layer 31 is subtracted from the separation distance dr derived from Expression (2.2), the film thickness of the light interference layer 31 can be calculated.

In addition, from Expression (1.4), a slope efficiency $\eta SE(0)$ where there is no reflection by the reflection surface is given by Expression (2.3) below.

$$\eta_{SE}(0) = \frac{h\nu}{e}\eta_i\frac{\frac{1}{2}\alpha_v}{\alpha_v + \alpha_{//} + \alpha_i} \qquad (2.3)$$

Accordingly, a slope efficiency $\eta SE(R)$ where there is reflection only needs to satisfy $\eta SE(R) > \eta SE(0)$ to increase the slope efficiency to be higher than that where there is no reflection, and the phase difference $\theta$ that satisfies this condition is given by Expression (2.4) below.

$$\cos\theta > -\frac{\sqrt{R}(\alpha_v + \alpha_p + \alpha_i)}{\alpha_v + 2(\alpha_p + \alpha_i)} \qquad (2.4)$$

In addition, the phase difference $\theta$ satisfying $\eta SE(R) < \eta SE(0)$ is given by Expression (2.5) below.

$$\cos\theta < -\frac{\sqrt{R}(\alpha_v + \alpha_p + \alpha_i)}{\alpha_v + 2(\alpha_p + \alpha_i)} \qquad (2.5)$$

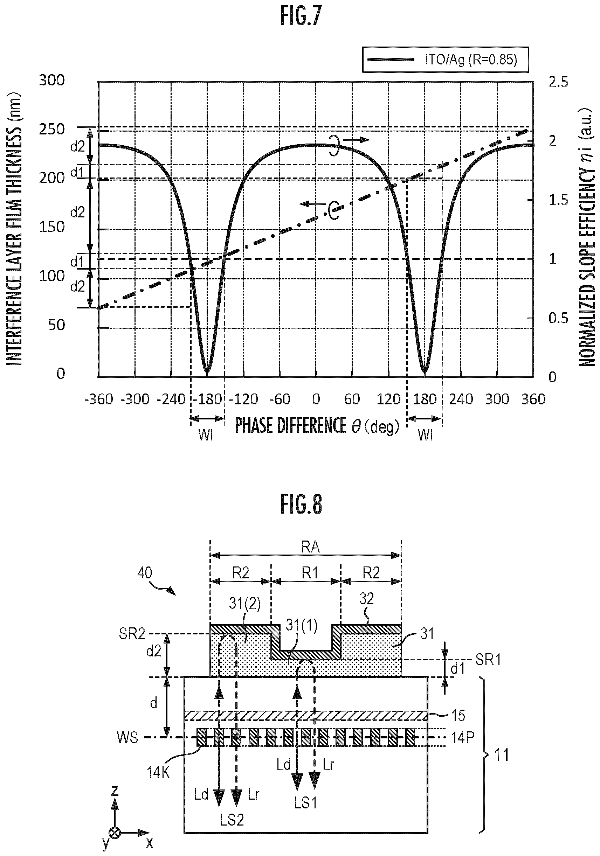

FIG. 7 is a diagram illustrating a relationship between the slope efficiency $\eta SE$ to the phase difference $\theta$ and an interference layer film thickness. A range of the phase difference $\theta$ where the direct diffracted light Ld and the reflected diffracted light Lr weaken each other, that is, a range of the phase difference $\theta$ where the normalized slope efficiency is lower than 1 is illustrated as a phase difference range WI. A phase difference range other than the phase difference range WI is the strengthening range. In the strengthening range, the slope efficiency is more preferably higher than 1. In addition, the interference layer film thickness (indicated by a one-dot chain line) is obtained by subtracting the distance d from the separation distance dr.

When the light interference layer 31 and the light reflection layer 32 are ITO/Ag (reflectivity R = 0.85) and $\alpha v/\alpha p = 20$, the weakening range and the strengthening range are represented by Expression (2.6) below due to the phase difference ($\theta$) dependence of the slope efficiency $\eta SE$ and the interference layer film thickness illustrated in FIG. 7.

· Weakening range: -208.4° < $\theta$ < -151.6° or 151.6° < $\theta$ < 208.4°
· Strengthening range: -360° $\leq \theta \leq$ -208.4° or -151.6° $\leq \theta \leq$ 151.6°
or

$$208.4° \leq \theta \leq 360° \qquad ...(2.6)$$

A separation distance dr from a wave source WS to the reflection surface SR when the phase difference $\theta$ is in the above range is obtained. A phase where the emitted light Lr reciprocates by dr only needs to be as described above, and thus the separation distance dr satisfies the following expression.

That is, weakening conditions are represented by Expression (2.7) below.

$$(m - 0.078)\lambda < 2n_{ave}dr < (m + 0.078)\lambda$$
$$\text{or, } (m + 0.921)\lambda < 2n_{ave}dr < (m + 1.078)\lambda \qquad (2.7)$$
$$(\text{Note that, } 0 \leq 2n_{ave}dr - (^1/_2 + m)\lambda < 1 \text{, m is an integer of 0 or more.})$$

In addition, strengthening conditions are represented by Expression (2.8).

$$(m - 0.5)\lambda \leq 2n_{ave}dr \leq (m - 0.078)\lambda$$
$$\text{or, } (m + 0.078)\lambda \leq 2n_{ave}dr \leq (m + 0.921)\lambda \qquad (2.8)$$
$$\text{or, } (m + 1.078)\lambda \leq 2n_{ave}dr \leq (m + 1.5)\lambda$$
$$(\text{Note that, } 0 \leq 2n_{ave}dr - (^1/_2 + m)\lambda < 1 \text{, m is an integer of 0 or more.})$$

When the separation distance dr of Expression (2.1) in the range of each of the phase differences θ of Expression (2.6) is calculated and the distance d between the diffraction surface WS and the light interference layer 31 is subtracted from the separation distance dr, the layer thickness d1 of the weakening region (central region R1) and the layer thickness d2 of the strengthening region (peripheral region R2) represented by Expression (2.9) below are obtained. The calculation is made with d = 1060 nm, λ = 435 nm, nave = 2.4, and m = 13.

· d1: 110.9 nm < d1 < 125.2 nm or 201.6 nm < d1 < 215.8 nm
· d2: 72.8 nm ≤ d2 ≤ 110.9 nm or 125.2 nm ≤ d2 ≤ 201.6 nm
or

$$215.8 \text{ nm} \leq d2 \leq 254 \text{ nm} \qquad ...(2.9)$$

By determining the layer thickness d1 of the central region R1 and the layer thickness d2 of the peripheral region R2 to satisfy Expression (2.9), the peripheral region R2 can be set to be brighter than the central region R1 (interference light intensity: LS1 < LS2), and beam control can be performed.

As schematically illustrated in FIG. 3, it is preferable that the layer thickness d2 of the strengthening region (peripheral region R2) is less than the layer thickness d1 of the weakening region (central region R1). This is because, while suppressing a reduction in emission intensity caused by the material loss of the light interference layer 31(2) in the strengthening region, laser light having a desired beam shape can be obtained.

Accordingly, it is more preferable that the minimum value of 110.9 nm of Expression (2.9) is adopted as the layer thickness d1 of the weakening region (central region R1) and the minimum value of 72.8 nm of Expression (2.9) is adopted as the layer thickness d2 of the strengthening region (peripheral region R2). In this case, the light interference layer 31 has a convex structure where the central region R1 is thicker than the peripheral region R2.

As described above, in the present embodiment, it is possible to provide a photonic-crystal surface-emitting laser where a beam shape can be easily and accurately controlled and beam (transverse mode) stability is excellent up to a high output.

(d) Modification Example

FIG. 8 is a schematic cross-sectional view illustrating a modification example of the first embodiment. In a PCSEL element 40 according to the present modification example, the layer thickness d2 of the strengthening region (peripheral region R2) is more than the layer thickness d1 of the weakening region (central region R1).

That is, the light interference layer 31 has a concave structure where the peripheral region R2 is thicker than the central region R1. Even in this case, it is possible to realize a photonic-crystal surface-emitting laser where a beam shape can be accurately controlled and beam (transverse mode) stability is excellent up to a high output.

[Second Embodiment]

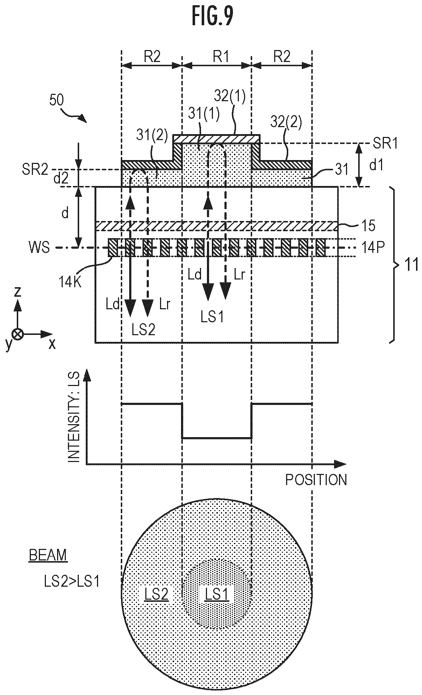

FIG. 9 is a diagram schematically illustrating a cross-section of a PCSEL element 50 according to a second embodiment, an interference light intensity, and a beam shape. In the present embodiment, a light reflection layer 32(1) is formed on the light interference layer 31(1), and a light reflection layer 32(2) having a different reflectivity from the light reflection layer 32(1) is formed on the light interference layer 31(2). Other points are the same as those of the PCSEL element 10 according to the first embodiment.

More specifically, the light interference layers 31(1) and 31(2) are ITO layers, the light reflection layer 32(1) is Pd (reflectivity R = 0.45), and the light reflection layer 32(2) is an Ag layer (reflectivity R = 0.85).

As in the PCSEL element 10 according to the first embodiment, the central region R1 is the weakening region, and the peripheral region R2 is the strengthening region. Accordingly, the intensities of the interference light LS1 and the interference light LS2 in the central region R1 and the peripheral region R2 satisfy LS1 < LS2. That is, the light reflection layer 32(1) having a relatively low reflectivity is applied to the weakening region where the intensities of the interference light weaken each other, and the light reflection layer 32(2) having a relatively high reflectivity is applied to the strengthening region where the intensities of the interference light strengthen each other.

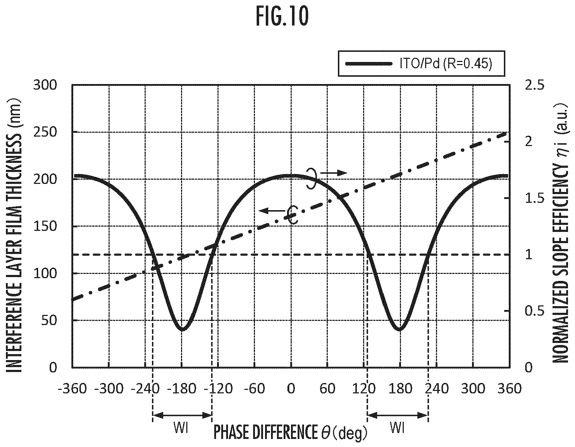

FIG. 10 is a diagram illustrating the phase difference ($\theta$) dependence of the interference layer thickness in the central region R1 where the light reflection layer 32(1) is Pd (reflectivity R = 0.45).

When the light reflection layer 32(1) is used, the weakening range and the strengthening range are obtained as in Expression (2.10) below.

· Weakening range: -230.2° < $\theta$ < -129.8° or 129.8° < $\theta$ < 230.2°
· Strengthening range: -360° ≤ $\theta$ ≤ -230.2° or -129.8° ≤ $\theta$ ≤ 129.8°
or

$$230.2° \leq \theta \leq 360° \qquad ...(2.10)$$

The layer thickness d1 of the weakening region (central region R1) is obtained by calculating the separation distance dr of Expression (2.1) in the range of each of the phase differences $\theta$ of Expression (2.10) and subtracting the distance d between the diffraction surface WS and the light interference layer 31 from the separation distance dr. The calculation is made with d = 1060 nm, $\lambda$ = 435 nm, nave = 2.4, and m = 13.

· d1:

$$105.4 \text{ nm} < d1 < 130.7 \text{ nm or } 196.1 \text{ nm} < d1 < 221.3 \text{ nm} \qquad \cdots(2.11)$$

Here, the light reflection layer 32(2) that is an Ag layer is applied to the strengthening region (peripheral region R2) according to the second embodiment. Therefore, the film thickness d2 is obtained as in Expression (2.9).

By determining the layer thickness d1 of the central region R1 to satisfy Expression (2.11) and determining the layer thickness d2 of the peripheral region R2 to satisfy Expression (2.9), the peripheral region R2 can be set to be brighter than the central region R1 (interference light intensity: LS1 < LS2), and beam control can be performed.

As schematically illustrated in FIG. 9, it is preferable that the layer thickness d2 of the strengthening region (peripheral region R2) is less than the layer thickness d1 of the weakening region (central region R1). This is because, while suppressing a reduction in emission intensity caused by the material loss of the light interference layer 31(2) in the strengthening region, laser light having a desired beam shape can be obtained.

Even in the present embodiment, it is more preferable that the minimum value of 104.8 nm of Expression (2.11) is adopted as the layer thickness d1 of the weakening region (central region R1) and the minimum value of 72.8 nm of Expression (2.11) is adopted as the layer thickness d2 of the strengthening region (peripheral region R2).

As described above, in the present embodiment, it is possible to provide a photonic-crystal surface-emitting laser where a beam shape can be easily and accurately controlled and beam (transverse mode) stability is excellent up to a high output.

[Third Embodiment]

A PCSEL element according to a third embodiment will be described below. In the present embodiment, the light interference layer 31 is divided into a first region R1, a second region R2, ..., and an n-th region Rn (n represents an integer of 3 or more) in order from the center.

That is, the light interference layer 31 includes the light interference layer 31(1), the light interference layer 31(2), ..., and the light interference layer 31(n). The light interference layer 31(1) is provided in the first region R1 as the central region, and the light interference layers 31(2), 31(3), ..., and 31(n) are provided in the peripheral region in this order from the side outside the first region R1.

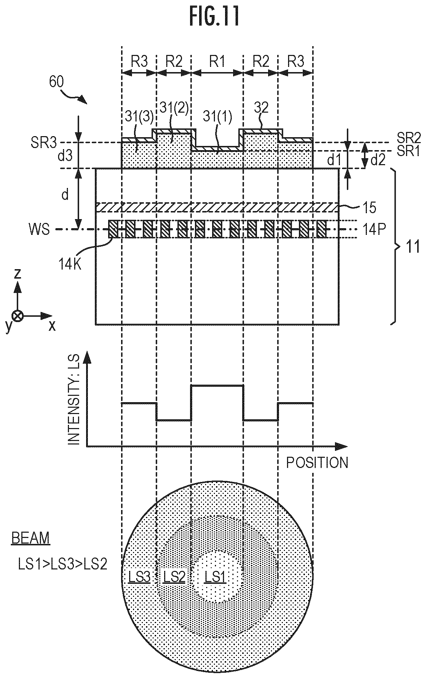

FIG. 11 is a diagram schematically illustrating a cross-section of a PCSEL element 60 according to the third embodiment, an interference light intensity, and a beam shape. FIG. 11 illustrates a case where, in the PCSEL element 60, the light interference layer 31 is divided into the first region R1, the second region R2, and the third region R3 (n = 3) in order from the center.

That is, the light interference layer 31 consists of the light interference layer 31(1), the light interference layer 31(2), and a light interference layer 31(3) in order from the center. The light reflection layer 32 is provided on the light interference layer 31.

More specifically, the diameters of the first region R1, the second region R2, and the third region R3 are 100 μm, 200 μm, and 300 μm, respectively.

The interference light intensity LS1 of the first region R1 (central region) is the highest, the interference light intensity LS2 of the second region R2 is the lowest, and an interference light intensity LS3 of the third region R3 is the intermediate intensity between the first region R1 and the second region R2.

That is, the layer thicknesses of the light interference layer 31(1), the light interference layer 31(2), and the light interference layer 31(3) are determined such that LS1 > LS3 > LS2 is satisfied. The layer thickness of each of the light interference layers can be determined based on the phase difference (θ) dependence of the interference layer thickness described in the first embodiment and the second embodiment.

Specifically, the layer thicknesses of the ITO layers of the light interference layer 31(1), the light interference layer 31(2), and the light interference layer 31(3) are 73 nm, 118 nm, and 103 nm, respectively.

The present embodiment is the same as the above-described embodiments in that it is possible to provide a photonic-crystal surface-emitting laser where a beam shape can be easily and accurately controlled and beam (transverse mode) stability is excellent up to a high output.

In particular, in the present embodiment, the second region R2 is provided between the first region R1 and the third region R3 that are regions having high interference light intensities, the second region R2 having a lower interference light intensity than the first region R1 and the third region R3. That is, the regions R1 and R3 having high interference light intensities can be provided to be separated from each other.

Accordingly, for example, when an object is heated by a light beam, a heating position and a heating process can be adjusted. For example, when welding is performed while moving an irradiation position of a light beam, preheating of a processing object using light of the region R3 that is previously irradiated in a propagation direction of the light beam can be performed, subsequently main processing using light of the region R1 can be performed, and subsequently annealing after processing using light of the region R3 can be performed. As a result, this configuration has an advantageous effect in that the quality of welding can be improved and the post-processes can also be performed at once.

The case where the light interference layer 31 consists of three regions has been described. In general, the same can apply to a case where the light interference layer 31 consists of the first region R1, the second region R2, ..., and the n-th region Rn.

In this case, the interference light intensity of each of the regions can be determined based on the phase difference (θ) dependence of the interference layer thickness such that a desired beam shape is obtained. That is, an interference light intensity LSj of a j-th region Rj (j = 1, 2, ..., and n) may be determined such that a desired intensity is obtained. In addition, as in the second embodiment, the light reflection layers 32(1) and 32(2) having different reflectivities may be applied.

Hereinabove, the embodiments of the present invention have been described in detail. In the above-described embodiments, the case where the light interference layer has a circular shape has been described. In the present invention, the term "circular shape" includes an elliptical shape and an oval shape, and the term "annular shape" includes an elliptical annular shape and an oval elliptical shape.

In addition, the light interference layer is not limited to a circular shape, and may have a shape such as a rectangular shape or a polygonal shape. It is preferable that the regions of the light interference layer have similar shapes concentric with each other.

In addition, dielectrics, reflective metals, and compositions, numerical values, and the like thereof in the above-described embodiments are merely exemplary, and appropriate modifications can be applied within the scope of the present invention. In addition, the PCSEL elements having the single lattice structure or the dual lattice structure have been described. However, the present invention is also applicable to a general PCSEL element having a multi-lattice structure.

In addition, the present invention exemplifies the air-hole layer in which the air hole has a hexagonal columnar shape, but also can be applied to a case where the air hole has a columnar shape, a rectangular shape, a polygonal shape, or an irregular columnar shape such as a teardrop shape.

As described above in detail, in the above-described present embodiment, it is possible to provide a photonic-crystal surface-emitting laser where a beam shape can be easily and accurately controlled and beam (transverse mode) stability is excellent up to a high output.

Description of Reference Numerals

    10, 40, 50, 60: PCSEL element
    12: substrate

14: n-side guide layer (first guide layer)
14K: air hole/air hole pair
14P: photonic crystal layer (air-hole layer)
15: active layer (ACT)
16: p-side guide layer (second guide layer)
20A: n-electrode
20B: p-electrode
31, 31(1), 31(2): light interference layer (translucent conductor layer)
32, 32(1), 32(2): light reflection layer
d: distance between diffraction surface WS and light interference layer 31
dr: separation distance
Ld: direct diffracted light
Lr: reflected diffracted light
R1: central region (first region)
R2: peripheral region (second region)
SR, SR1, SR2: reflection surface
WS: diffraction surface (wave source)

**Claims**

1. A surface-emitting laser element comprising:

    a translucent substrate;
    an n-type semiconductor layer provided on the substrate;
    an active layer provided on the n-type semiconductor layer;
    a p-type semiconductor layer provided on the active layer;
    an air-hole layer that is a photonic crystal layer included in the n-type semiconductor layer and including air holes disposed with two-dimensional periodicity in a plane parallel to the active layer,
    a light reflection layer provided on the p-type semiconductor layer and including a reflection surface; and
    a translucent conductor layer provided between the reflection surface and the p-type semiconductor layer,
    wherein a light emission surface is provided on a back surface of the substrate,
    the air-hole layer has a diffraction surface that is a wave source when light standing in the air-hole layer is diffracted in a direction orthogonal to the air-hole layer,
    a weakening region where a separation distance between the diffraction surface and the reflection surface is provided such that a light intensity of interference light generated by interference of first diffracted light diffracted from the diffraction surface to the light emission surface side and second diffracted light diffracted from the diffraction surface to the light reflection layer side and reflected by the reflection surface is lower than a light intensity of the first diffracted light is provided, and
    a strengthening region where a separation distance between the diffraction surface and the reflection surface is provided such that the light intensity of the interference light is higher than the light intensity of the first diffracted light is provided.

2. The surface-emitting laser element according to claim 1,

    wherein the translucent conductor layer includes a first region layer, a second region layer, ..., and a k-th region layer (k represents an integer of 2 or more) in order from a center,
    the first region layer is provided in the weakening region, and
    the second region layer is provided in the strengthening region and has a different layer thickness from the first region layer.

3. The surface-emitting laser element according to claim 2,
    wherein the second region layer has a smaller layer thickness than the first region layer.

4. The surface-emitting laser element according to claim 2 or 3,
    wherein the light reflection layer in the first region layer and the light reflection layer in the second region layer have different reflectivities.

**5.** The surface-emitting laser element according to claim 1,

wherein the translucent conductor layer includes at least a first region layer, a second region layer, and a third region layer,
the first region layer and the third region layer of the translucent conductor layer are provided in the strengthening region, and
the second region layer is provided in the weakening region.

**6.** The surface-emitting laser element according to any one of claims 1 to 5,

wherein when a phase difference between the first diffracted light diffracted by the diffraction surface and the second diffracted light diffracted by the diffraction surface and reflected by the reflection surface is represented by $\theta$ (deg), a wavelength of the first diffracted light is represented by $\lambda$, an average refractive index of the layer from the diffraction surface to the reflection surface is represented by $n_{ave}$, and an integer of 0 or more is represented by m, the separation distance is represented by the following expression,

$$dr = \left(\frac{\theta}{360°} + 0.5 + m\right)\frac{\lambda}{2n_{ave}} \qquad (2.1)$$

when a reflectivity of the reflection surface is represented by R, losses of the air-hole layer in an in-plane direction and a perpendicular direction of the air-hole layer are represented by $\alpha p$ and $\alpha v$, respectively, and an internal loss is represented by $\alpha i$, the phase difference $\theta$
satisfies the following expression in the weakening region, and

$$\cos\theta > -\frac{\sqrt{R}(\alpha_v + \alpha_p + \alpha_i)}{\alpha_v + 2(\alpha_p + \alpha_i)} \qquad (2.4)$$

satisfies the following expression in the strengthening region.

$$\cos\theta < -\frac{\sqrt{R}(\alpha_v + \alpha_p + \alpha_i)}{\alpha_v + 2(\alpha_p + \alpha_i)} \qquad (2.5)$$

**7.** The surface-emitting laser element according to any one of claims 1 to 6,
wherein the translucent conductor layer has a circular shape.

## FIG.1A

## FIG.1B

## FIG.2A

21

31,32

CX

## FIG.2B

14P

14K1

14K2

14K

14R

## FIG.2C

20A

20L

RA

14R

CX

20C

# FIG.3

FIG.4

## FIG.5

## FIG.6

EP 4 481 963 A1

FIG.7

FIG.8

21

# FIG.9

# FIG.10

# FIG.11

BEAM
LS1>LS3>LS2

## INTERNATIONAL SEARCH REPORT

| | International application No. |
|---|---|
| | **PCT/JP2023/009788** |

**A.    CLASSIFICATION OF SUBJECT MATTER**

*H01S 5/11*(2021.01)i; *H01S 5/185*(2021.01)i
FI:    H01S5/11; H01S5/185

According to International Patent Classification (IPC) or to both national classification and IPC

**B.    FIELDS SEARCHED**

Minimum documentation searched (classification system followed by classification symbols)

H01S5/00-5/50

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| A | WO 2022/014343 A1 (KYOTO UNIV.) 20 January 2022 (2022-01-20)<br>entire text, all drawings | 1-7 |
| A | WO 2021/186965 A1 (KYOTO UNIV.) 23 September 2021 (2021-09-23)<br>entire text, all drawings | 1-7 |
| A | WO 2019/221133 A1 (HAMAMATSU PHOTONICS K.K.) 21 November 2019 (2019-11-21)<br>entire text, all drawings | 1-7 |
| A | US 10340659 B1 (CONARY ENTERPRISE CO., LTD.) 02 July 2019 (2019-07-02)<br>entire text, all drawings | 1-7 |

☐ Further documents are listed in the continuation of Box C.        ☑ See patent family annex.

| | |
|---|---|
| *    Special categories of cited documents:<br>"A"    document defining the general state of the art which is not considered to be of particular relevance<br>"E"    earlier application or patent but published on or after the international filing date<br>"L"    document which may throw doubts on priority claim(s) or which is cited to establish the publication date of another citation or other special reason (as specified)<br>"O"    document referring to an oral disclosure, use, exhibition or other means<br>"P"    document published prior to the international filing date but later than the priority date claimed | "T"    later document published after the international filing date or priority date and not in conflict with the application but cited to understand the principle or theory underlying the invention<br>"X"    document of particular relevance; the claimed invention cannot be considered novel or cannot be considered to involve an inventive step when the document is taken alone<br>"Y"    document of particular relevance; the claimed invention cannot be considered to involve an inventive step when the document is combined with one or more other such documents, such combination being obvious to a person skilled in the art<br>"&"    document member of the same patent family |

| Date of the actual completion of the international search | Date of mailing of the international search report |
|---|---|
| **24 May 2023** | **06 June 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/009788**

| Patent document cited in search report | | | Publication date (day/month/year) | Patent family member(s) | | | Publication date (day/month/year) |
|---|---|---|---|---|---|---|---|
| WO | 2022/014343 | A1 | 20 January 2022 | (Family: none) | | | |
| WO | 2021/186965 | A1 | 23 September 2021 | EP | 4105967 | A1 | |
| | | | | CN | 115298916 | A | |
| | | | | TW | 202139550 | A | |
| WO | 2019/221133 | A1 | 21 November 2019 | US | 2021/0273411 | A1 | |
| | | | | DE | 112019002461 | T | |
| | | | | CN | 112119548 | A | |
| | | | | TW | 202007031 | A | |
| US | 10340659 | B1 | 02 July 2019 | (Family: none) | | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018155710 A
- JP 2020045573 A
- JP 2019208004 A

**Non-patent literature cited in the description**

- **Y. LIANG et al.** *Phys. Rev. B*, 2011, vol. 84, 195119